(19) Europäisches Patentamt

European Patent Office

Office européen des brevets

(11) **EP 0 825 719 A2**

(12) **EUROPÄISCHE PATENTANMELDUNG**

(43) Veröffentlichungstag:
   **25.02.1998  Patentblatt 1998/09**

(51) Int. Cl.⁶: **H03L 7/093**, H03L 7/099

(21) Anmeldenummer: 97202545.6

(22) Anmeldetag: **19.08.1997**

(84) Benannte Vertragsstaaten:
   **AT BE CH DE DK ES FI FR GB GR IE IT LI LU MC NL PT SE**

(30) Priorität: **23.08.1996 DE 19634084**

(71) Anmelder:
   • **Philips Patentverwaltung GmbH
     22335 Hamburg (DE)**
     Benannte Vertragsstaaten:
     **DE**
   • **Philips Electronics N.V.
     5621 BA  Eindhoven (NL)**
     Benannte Vertragsstaaten:
     **FR GB**

(72) Erfinder:
   • **Meyer, Robert
     Röntgenstrasse 24, 22335 Hamburg (DE)**
   • **Suwald, Thomas
     Röntgenstrasse 24, 22335 Hamburg (DE)**

(74) Vertreter:
   **von Laue, Hanns-Ulrich, Dipl.-Ing. et al
   Philips Patentverwaltung GmbH,
   Röntgenstrasse 24
   22335 Hamburg (DE)**

(54) **Phasenregelkreis**

(57)    Bei einem Phasenregelkreis mit einem Phasendetektor (1), einem Schleifenfilter (5) und einem gesteuerten Oszillator (17), die auf einem gemeinsamen integrierten Schaltkreis aufgebaut sind, soll eine Störunterdrückung gegen auf von anderen Schaltungsteilen auf das Substrat des integrierten Schaltkreises eingekoppelte Störungen erzielt werden.

Dies wird gemäß einer ersten Ausführungsform der Erfindung dadurch erzielt, daß dem gesteuerten Oszillator (17) ein kapazitiver Spannungsteiler (9), der wenigstens zwei Kapazitäten (10,12) aufweist, vorgeschaltet ist, daß der gesteuerte Oszillator (17) in Abhängigkeit des Ausgangssignals des kapazitiven Spannungsteilers (9) gesteuert wird und daß der kapazitive Spannungsteiler (9) mit dem Phasendetektor (1), dem Schleifenfilter (5) und dem gesteuerten Oszillator (17) auf einem integrierten Schaltkreis aufgebaut ist.

Gemäß einer zweiten Ausführungsform der Erfindung wird die Störverminderung dadurch erzielt, daß der gesteuerte Oszillator (17) differentiel aufgebaut ist und wenigstens zwei spannungsgesteuerte Stromquellen (18,19) aufweist, deren Schaltungen mit einem Versorgungspotential und mit einem Substrat gekoppelt sind, auf dem der integrierte Schaltkreis aufgebaut ist, daß der geteuerte Oszillator (17) eine Auskoppelstufe (20) aufweist, die den spannungsgesteuerten Stromquellen (18,19) nachgeschaltet ist und die in Abhängigkeit der ihr zugeführten differentiellen Signale zwei differentielle digitale Signale generiert, die mittels Umschaltung zwischen zwei Potentialen mit hoher Flankensteilheit erzeugt werden und die Verstärkerstufen (56,57) zugeführt werden, die zwischen Versorgungspotential und Bezugspotential geschaltet sind und die zwei auf Bezugspotential bezogene differentielle Ausgangssignale liefern.

Fig.1

EP 0 825 719 A2

**Beschreibung**

Die Erfindung betrifft einen Phasenregelkreis mit einem Phasendetektor, einem Schleifenfilter und einem gesteuerten Oszillator, die auf einem integrierten Schaltkreis realisiert sind.

Ein derartiger vollintegrierter Phasenregelkreis ist beispielsweise aus den PHILIPS IC's SAA 7196, SAA 7110 und SAA 7111 bekannt. Bei derartigen Phasenregelkreisen, die englisch meist als Phase Locked Loop (PLL) bezeichnet werden, besteht das Problem, daß auf die Elemente des Phasenregelkreises, also den Phasendetektor, das Schleifenfilter und/oder den gesteuerten Oszillator sowie weitere gegebenenfalls vorgesehene Schaltungselemente der PLL Störspannungen innerhalb des integrierten Schaltkreises eingekoppelt werden. Ein integrierter Schaltkreis ist auf einem Substrat aufgebaut, auf das weitere Schichten aufgebracht werden, in denen die Schaltungen realisiert werden. Die Schaltungen selbst stehen mit dem Substrat nicht unmittelbar in Verbindung, jedoch werden durch kapazitive Koppelungen Signale aus den Schaltungen, die auf dem Substrat aufgebaut sind, auf das Substrat gekoppelt. Dies geschieht auch in umgekehrter Weise, d.h. es werden diese Störungen aus dem Substrat in wiederum andere Schaltungselemente eingekoppelt. Dieses Problem wird gegebenenfalls dadurch verschärft, daß auf einem derartigen integriereten Schaltkreis sowohl analoge wie auch digitale Schaltungen aufgebaut sind. Digitale Schaltungen arbeiten meist mit Signalen mit relativ steilen Flanken, die kapazitiv besonders intensiv auf das Substrat gekoppelt werden. Diese werden dann auf ebenfalls auf dem Stubstrat aufgebaute analoge Schaltungen über kapazitive Kopplung gekoppelt. Damit treten in den analogen Schaltungen bzw. in den von diesen Schaltungen geführten Signalen deutliche Störungen auf. Für einen Phasenregelkreis der oben bezeichneten Art bedeutet dies, daß das Ausgangssignal von Phasenschwankungen, englisch als Jitter bezeichnet, überlagert sind. Dies ist im Regelfalle unerwünscht.

Es ist Aufgabe der Erfindung, eine auf einem integrierten Schaltkreis aufgebaute PLL unempfindlicher gegen Störungen der oben genannten Art zu machen.

Diese Aufgabe ist für eine erste Ausführungsform der Erfindung dadurch gelöst, daß dem gesteuerten Oszillator ein kapazitiver Spannungsteiler, der wenigstens zwei Kapazitäten aufweist, vorgeschaltet ist, daß der gesteuerte Oszillator in Abhängigkeit des Ausgangssignals des kapazitiven Spannungsteilers gesteuert wird und daß der kapazitive Spannungsteiler mit dem Phasendetektor, dem Schleifenfilter und dem gesteuerten Oszillator auf einem integrierten Schaltkreis aufgebaut ist.

Dem Phasendetektor und dem Schleifenfilter ist ausgangsseitig ein kapazitiver Spannungsteiler nachgeschaltet. Dieser teilt die Ausgangsspannung eines Kopplungspunktes des Schleifenfilters je nach Wahl der Werte der Kapazitäten des kapazitiven Spannungsteilers herunter. Das so heruntergeteilte Signal, also das Ausgangssignal des kapazitiven Spannungsteilers wird dann auf den gesteuerten Oszillator gekoppelt, der in Abhängigkeit der Werte dieses Eingangssignals ein Ausgangssignal variierender Frequenz liefert.

Der kapazitive Spannungsteiler teilt jedoch nicht nur das Nutz-Ausgangssignal des Schleifenfilters herunter, sondern auch bis zu diesem Punkt in den Phasenregelkreis eingekoppelte Störungen. Derartige Störungen, die über Koppelkapazitäten insbesondere von dem Substrat des integrierten Schaltkreises her eingekoppelt werden, werden um das Teilerverhältnis des kapaziven Spannungsteilers vermindert. Das Ausgangssignal des Phasendetektors und des Schleifenfilters wird so dimensioniert, daß es hinter dem kapazitiven Spannungsteiler die gewünschte Größe aufweist.

Damit wird eine Verringerung der Störempfindlichkeit des Phasenregelkreises erzielt, ohne daß dadurch andere Nachteile einträten. Es gäbe grundsätzlich auch die Möglichkeit, die Integrationskapazität zu vergrößern, um die Störempfindlichkeit zu verringern. Damit würde jedoch einerseits der Nachteil eintreten, daß das dynamische Verhalten der PLL in unerwünschter Weise verändert würde, und außerdem würde die Kapazität des Schleifenfilters eine größere Fläche auf dem Substrat erfordern. Durch die erfindungsgemäße Lösung werden diese Nachteile vermieden, und es wird insbesondere ohne Veränderung des dynamischen Verhaltens des Phasenregelkreises eine Verminderung der Störempfindlichkeit des Phasenregeikreises erzielt. Damit weist das Ausgangssignal des Phasenregelkreises einen verminderten Jitter auf.

Für eine Ausgestaltung der ersten Ausführungsform der Erfindung ist vorgesehen, daß wenigstens eine erste Kapazität des kapazitiven Spannungsteilers in den Signalweg zwischen dem Phasendetektor und dem Schleifenfilter einerseits und dem gesteuerten Oszillator andererseits geschaltet ist und daß wenigstens eine zweite Kapazität des kapazitiven Spannungsteilers zwischen diesen Signalweg und ein Versorgungspotential geschaltet ist. Dabei bestimmen die Werte der beiden Kapazitäten das Spannungsteilerverhältnis des kapazitiven Spannungsteilers.

Gemäß weiteren Ausgestaltungen der ersten Ausführungsform der Erfindung ist vorgesehen, daß der gesteuerte Oszillator einen Spannungs-/Strom-Wandler aufweist, in Abhängigkeit von dessen Ausgangsstrom die Frequenz des Ausgangssignals des gesteuerten Oszillators variiert wird und daß wenigstens eine erste Kapazität des kapazitiven Spannungsteilers in den Signalweg zwischen dem Phasendetektor und dem Schleifenfilter einerseits und dem Spannungs-/Strom-Wandler andererseits geschaltet ist und daß wenigstens eine zweite Kapazität des kapazitiven Spannungsteilers zwischen diesen Signalweg und ein Versorgungspotential geschaltet ist.

Ist der gesteuerte Oszillator so aufgebaut, daß er eingangsseitig einen Spannungs-/Strom-Wandler aufweist, in Abhängigkeit von dessen (Strom) Ausgangssignal ein Oszillator angesteuert wird, so wird das Ausgangssignal des kapazitiven Spannungsteilers, das eine Spannung darstellt, dem Eingang des Spannungs-/Strom-Wandlers zugeführt, der dieses in ein Stromsignal wandelt, mittels dessen dann der eigentliche Oszillator angesteuert wird.

Gemäß einer weiteren Ausgestaltung der ersten Ausführungsform der Erfindung ist wenigstens ein als Diode verschalteter Transistor vorgesehen, mittels welchem das Gleichspannungs-Potential am Ausgang des kapazitiven Spannungsteilers eingestellt wird. Dem kapazitiven Spannungsteiler geht der Gleichspannungsanteil am Ausgang des Phasendetektors bzw. des Schleifenfilters verloren. Dieser Gleichspannungsanteil wird durch die Diode wieder hergestellt. Dabei sind vorteilhaft zwei gegeneinander verschaltete Dioden vorgesehen, so daß eine Reaktion auf Abweichungen der Gleichspannungen beider Polaritäten am Ausgang und am Eingang des kapazitiven Spannungsteilers durch diese Dioden erfolgen kann. Damit verbessern die Dioden das Ein- und Ausschaltverhalten des Phasenregelkreises, da hierbei besonders große Gleichspannungs-Offsets entstehen. Es tritt sogar eine Verbesserung gegenüber den Lösungen nach dem Stande der Technik ein, die keinen kapazitiven Spannungsteiler aufweisen, da die Einschalt-Zeitkonstante des Regelkreises im Verhältnis des kapazitiven Spannungsteilers reduziert wird. Darüber hinaus werden durch die Dioden Leckströme, die in integrierten Schaltkreisen auftreten, am Ausgang des kapazitiven Spannungsteilers kompensiert.

Die oben angegebene Aufgabe ist durch eine zweite Ausführungsform der Erfindung dadurch gelöst, daß der gesteuerte Oszillator differentiell aufgebaut ist und wenigstens zwei spannungsgesteuerte Stromquellen aufweist, deren Schaltungen mit einem Versorgungspotential und mit einem Substrat gekoppelt sind, auf dem der integrierte Schaltkreis aufgebaut ist, daß der geteuerte Oszillator eine Auskoppelstufe aufweist, die den spannungsgesteuerten Stromquellen nachgeschaltet ist und die in Abhängigkeit der ihr zugeführten differentiellen Signale zwei differentielle digitale Signale generiert, die mittels Umschaltung zwischen zwei Potentialen mit hoher Flankensteilheit erzeugt werden und die Verstärkerstufen zugeführt werden, die zwischen Versorgungspotential und Bezugspotential geschaltet sind und die zwei auf Bezugspotential bezogene differentielle Ausgangssignale liefern. Der gesteuerte Oszillator ist differentiell aufgebaut. Dies bedeutet, daß das in ihm geführte Nutzsignal jeweils in Form zweier Signale entgegengesetzter Polarität vorliegt. In diese beiden Signale eingekoppelte Störungen werden jedoch jeweils mit gleicher Polarität eingekoppelt. Bei Substraktion der beiden differentiellen Signale heben sich die Störungen auf, die Nutzsignale überlagern sich jedoch gleichsinnig.

Dieser differentiell aufgebaute Oszillator weist wenigstens zwei gesteuerte Stromquellen auf, deren Schaltungen mit einem Versorgungspotential und dem Substrat des integrierten Schaltkreises, auf dem der Phasenregelkreis aufgebaut ist, gekoppelt ist. Üblicherweise würde der gesteuerte Oszillator mit dem Versorgungspotential und dem Bezugspotential, das auch für den übrigen Phasenregelkreis als solches vorgesehen ist, gekoppelt werden. Dieses Bezugspotential ist nicht identisch mit dem Potential des Substrats des integrierten Schaltkreises. Durch den Bezug auf das Potential des Substrats arbeitet die gesamte Schaltung relativ zu dessen Potential und damit auch zu dem auf das Potential durch andere Schaltungselemente eingekoppelten Störungen. Somit treten in den Signalen des Oszillators dieses Störungen nicht auf, da die Signale auf das Potential des Substrats bezogen sind. Somit sind die Störungen auf dem Substrat für diese Schaltungselemente des Oszillators, die mit dem Substrat gekoppelt sind, nicht wirksam.

Da der übrige Phasenregelkreis jedoch mit Schaltungselementen arbeitet, die auf Bezugspotential bezogen arbeiten, muß der gesteuerte Oszillator ausgangsseitig Ausgangssignale liefern, die ebenfalls auf das Bezugspotential bezogen sind. Dazu ist in dem gesteuerten Oszillator eine Auskoppelstufe vorgesehen, die die differentiellen Signale, die auf das Substrat bezogen sind, in differentielle Ausgangssignale wandelt, die auf das Bezugspotential bezogen sind. Grundsätzlich tritt hierbei das Problem auf, daß bei dieser Umwandlung auch die auf das Substrat eingekoppelten Störungen wieder wirksam werden. Dieses wird dadurch vermieden, daß in der Auskoppelstufe elektronische Schalter vorgesehen sind, die in Abhängigkeit der Eingangssignale, also der Ausgangssignale einer der spannungsgesteuerten Stromquellen, geschaltet werden und somit zwischen zwei Spannungszuständen hart umgeschaltet werden. Durch diese harte Umschaltung sind in den Ausgangssignalen, die auf das Bezugspotential bezogen sind, die Störungen, die dem analogen Eingangssignal noch überlagert sind, nicht mehr vorhanden. Das Ausgangssignal ist auf das Bezugspotential bezogen und stellt quasi ein digitales Signal dar, das jedoch die wesentliche Information, nämlich die Schwingungsfrequenz des gesteuerten Oszillators, nach wie vor enthält, indem jedoch die Störungen, die von dem Substrat her eingekoppelt werden, unterdrückt sind. Dies wird dadurch erreicht, daß der analog arbeitende Oszillator durch Bezug auf das Substrat-Potential störungsfrei arbeitet und nachfolgend durch die Ausgangsstufe bei der Wandlung in Signale, die auf Bezugspotential bezogen sind, auftretende Störungen unterdrückt werden.

Der spannungsgesteuerte Oszillator kann, wie gemäß einer Ausgestaltung der zweiten Ausführungsform der Erfindung vorgesehen ist, mittels eines Stromes angesteuert werden, der ersten Vorsorgungsanschlüssen der spannungsgesteuerten Stromquellen zugeführt wird, deren zweite Versorgungsanschlüsse mit dem Substrat des integrierten Schaltkreises gekoppelt sind. In Abhängigkeit des diesen Versorgungsanschlüssen zugeführten Stromes wird die Frequenz der Oszillatorschaltung variiert. Dabei sind die spannungsgesteuerten Stromquellen vorteilhafterweise, wie gemäß einer weiteren Ausgestaltung der zweiten Ausführungsform der Erfindung vorgesehen ist, so verschaltet, daß eine erste und eine zweite spannungsgesteuerte Stromquelle vorgesehen sind, welche jeweils einen nichtinvertierenden und einen invertierenden Eingang und einen nicht-invertierenden und einen invertierenden Ausgang aufweisen, daß beide Ausgangssignale beider spannungsgesteuerten Stromquellen jeweils mittels wenigstens einer, gegebenenfalls ausschließlich durch parasitäre Kapazitäten gebildeten, Kapazität miteinander gekoppelt sind, daß der invertierende Ausgang der ersten spannungsgesteuerten Stromquelle mit dem nichtinvertierenden Eingang der zweiten spannungsgesteuerten Stromquelle und der nichtinvertierende Ausgang der ersten spannungsgesteuerten Stromquelle mit dem invertierenden Eingang der zweiten spannungsgesteuerten Stromquelle gekoppelt ist, daß der invertierende Ausgang der zweiten spannungsgesteuerten Stromquelle dem invertierenden Eingang der ersten spannungsgesteuerten Stromquelle und der nichtinvertierende Ausgang der zweiten spannungsgesteuerten Stromquelle mit dem nichtinvertierenden Eingang der ersten spannungsgesteuerten Stromquelle gekoppelt ist und daß die Ausgangssignale der zweiten spannungsgesteuerten Stromquelle die differentiellen Signale darstellen die auf die Auskoppelstufe geführt sind. Die spannungsgesteuerten Stromquellen können dabei als Inverter realisiert sein.

Eine weitere Steigerung der Störunempfindlichkeit des Phasenregelkreises wird durch Kombination beider Ausführungsformen der Erfindung erzielt. Dazu ist gemäß einer weiteren Ausgestaltung der Erfindung vorgesehen, daß der gesteuerte Oszillator in Abhängigkeit des Ausgangssignals des kapazitiven Teilers angesteuert wird. Damit wird erreicht, daß eine doppelte Reduktion der durch das Substrat eingekoppelten Störungen eintritt.

Nachfolgend wird ein Ausführungsbeispiel der Erfindung näher erläutert, in dem beide Ausführungsformen der Erfindung realisiert sind. Es zeigen:

Fig. 1 ein Schaltbild eines Phasenregelkreises mit einem kapazitiven Spannungsteiler gemäß der ersten Ausführungsform und einem gesteuerten Oszillator gemäß der zweiten Ausführungsform der Erfindung und
Fig. 2 ein Detailschaltbild einer Auskoppelstufe der Schaltung gemäß Fig. 1.

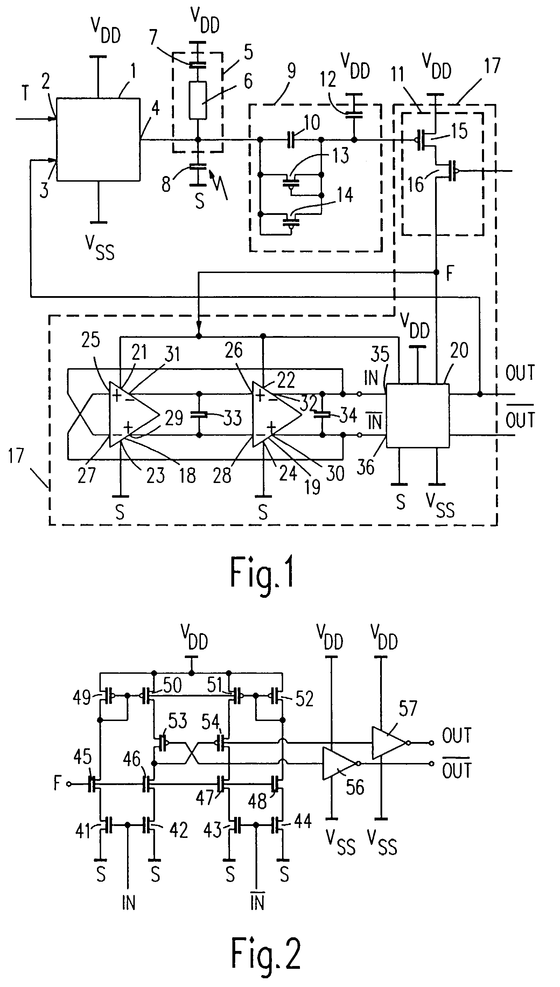

Der in Fig. 1 teilweise schematisch, teilweise im Detailschaltbild dargestellte Phasenregelkreis weist einen als Schaltungsblock dargestellten Phasendetektor 1 auf. In der Figur nicht dargestellte Schaltungselemente des Phasenregelkreises arbeiten bezogen auf ein Versorgungspotential $V_{DD}$ und ein Bezugspotential $V_{ss}$. Diese Potentiale sind nicht identisch mit dem Potential S eines Substrats, auf dem alle Schaltungselemente des Phasenregelkreises gemäß Fig. 1 aufgebaut sind. Einem ersten Eingang 2 des Phasendetektors 1 wird ein Eingangssignal T zugeführt, auf das der Phasenregelkreis einrasten soll. Einem zweiten Eingang 3 des Phasendetektors 1 wird das gegebenenfalls heruntergeteilte Ausgangssignal der Schaltungsanordnung gemäß Fig. 1 zugeführt, das mit OUT gekennzeichnet ist. In Abhängigkeit der Phasendifferenz der Eingangssignale an den Eingängen 2 und 3 liefert der Phasendetektor 1 ein Ausgangssignal an seinem Ausgang 4, das einem Schleifenfilter 5 zugeführt wird. Das Schleifenfilter 5 weist beispielsweise einen außerhalb des Substrats zu realisierenden Widerstand 6 und eine Kapazität 7 auf. Durch das Schleifenfilter 5 werden die dynamischen Eigenschaften des Phasenregelkreises bestimmt.

In Fig. 1 ist ferner eine Kapazität 8 angedeutet, die mit dem Potential S des Substrates gekoppelt ist, auf der der Phasenregelkreis gemäß Fig. 1 aufgebaut ist. Auf dieses Substrat S werden durch grundsätzlich unerwünschte Koppelkapazitäten Potentialimpulse anderer, auf dem gleichen Substrat vorgesehener Schaltungsanordnungen eingekoppelt. Über die ebenfalls nicht zu vermeidende Koppelkapazität 8 werden diese Störungen wiederum in den Phasenregelkreis gemäß Fig. 1 eingekoppelt. Damit wird das Ausgangssignal des Phasendetektors 1 bzw. des Schleifenfilters 5 von diesen kapazitiv eingekoppelten Störungen überlagert. Diese Überlagerung führt dazu, daß ein nachgeschalteter gesteuerter Oszillator unerwünschte Frequenzschwankungen seines Ausgangssignals aufweist. Diese werden meist als Jitter bezeichnet und sind unerwünscht.

Zur Unterdrückung dieser Störungen wird das Ausgangssignal des Phasendetektors 1 bzw. des Schleifenfilters 5 einem kapazitiven Spannungsteiler 9 zugeführt. Der kapazitive Spannungsteiler weist eine erste Kapazität 10 auf, die eingangsseitig mit dem Ausgangssignal des Phasendetektors 1 bzw. Schleifenfilters 5 und ausgangsseitig mit einem Spannungs-/Strom-Wandler 11 gekoppelt ist. Der Längskapazität 10 ist eine mit dem Versorgungspotential $V_{DD}$ gekoppelte zweite Kapazität 12 nachgeschaltet. Die Kapazitätswerte der Kapazitäten 10 und 11 bestimmen dabei das Teilerverhältnis, in dem die Spannungen, die dem kapazitiven Spannungsteiler 9 eingangsseitig zugeführt werden, heruntergeteilt werden.

Durch das Herunterteilen der Eingangsspannungen werden insbesondere die über die Kapazität 8 und über das Substrat eingekoppelten Störungen reduziert. Dabei ist wichtig, daß die Schaltungselemente des kapazitiven Spannungsteilers vom Potential des Substrats entkoppelt sind. Das Ausgangssignal des Phasendetektors 1 wird zwar auch entsprechend reduziert, jedoch kann dieses bezüglich seiner Größe unproblematisch variiert werden. Die Größe des Ausgangssignals des Phasendetektors 1 kann also so gewählt werden, daß am Ausgang des kapazitiven Spannungsteilers 9 ein Nutzsignal mit der gewünschten Größe erzielt wird. Dann werden jedoch die über die Kapazität 8 eingekoppelten Störungen entsprechend dem Teilerverhältnis des kapazitiven Spannungsteilers reduziert. Dabei ist es nicht erforderlich, den Wert der Kapazität 7 des Schleifenfilters zu erhöhen, da durch den kapazitiven Spannungsteiler 9 das Ausgangssignal des Phasendetektors 1 entsprechend dem Teilverhältnis des kapazitiven Spannungsteilers 9 heruntergeteilt wird. Damit wird der Nachteil vermieden, daß durch eine anderenfalls zur Störunterdrückung erforderliche Vergrößerung der Kapazität 7 eine Veränderung des dynamischen Verhaltens einträte.

Der kapazitive Spannungsteiler 9 weist ferner einen ersten Transistor 13 und einen zweiten Transistor 14 auf, bei denen es sich um P-dotierte MOS-Feldeffekttransistoren handelt. Beide Transistoren sind als Dioden verschaltet und gegeneinander parallel zu der ersten Kapazität 10 des kapazitiven Spannungsteilers 9 verschaltet. Die als Dioden verschalteten Transistoren 13 und 14 stellen am Ausgang des kapazitiven Spannungsteilers 9 wieder diejenige Gleichspannung ein, die durch die Kapazität 10 unterdrückt wird. Damit werden zum einen Leckströme, die insbesondere am Eingang 11 des nachgeschalteten Spannungs-/Strom-Wandlers eintreten, kompensiert. Zum anderen wird das Hochlaufverhalten des Phasenregelkreises verbessert da beim Hochlaufen im Ausgangssignal des Phasendetektors 1 auftretende, relativ große Gleichspannungsanteile über die Diode 14 auf den Ausgang des kapazitiven Spannungsteiles 9 übertragen werden, so daß das dynamische Verhalten des Phasenregelkreises durch den kapazitiven Spannungsteiler nicht leidet. Tatsächlich tritt durch die Verschaltung der Dioden 13 und 14 sogar ein verbessertes dynamisches Verhalten gegenüber Schaltungen, die den kapazitiven Spannungsteiler und die Dioden 13, 14 nicht aufweisen, ein.

Das Ausgangssignal des kapazitiven Spannungsteilers 9 gelangt auf den Gate-Eingang eines P-MOS-Feldeffekt-Transistors 15 des Spannungs-/Strom-Wandlers 11, der in einem gesteuerten Oszillator 17 vorgesehen ist. Der Source-Anschluß des Transistors 15 ist mit Bezugspotential $V_{DD}$ gekoppelt, sein Drain-Anschluß ist auf einen weiteren P-MOS-Transistor 16 gekoppelt, der als Kaskode verschaltet ist und der ausgangsseitig ein Steuersignal F liefert.

Der gesteuerte Oszillator 17 weist zwei gesteuerte Stromquellen 18 und 19 auf, die den eigentlichen gesteuerten Oszillator darstellen. Den gesteuerten Stromquellen 18 und 19 ist eine Auskoppelstufe 20 nachgeschaltet, die das eigentliche Ausgangssignal des gesteuerten Oszillators 17 liefert, das einerseits das Ausgangssignal des gesamten Phasenregelkreises darstellt und das andererseits dem zweiten Eingang 3 des Phasendetektors 1 zugeführt wird.

Der gesteuerte Oszillator 17 und insbesondere auch die spannungsgesteuerten Stromquellen 18 und 19 samt ihrer Verschaltung sind differentiell aufgebaut. Dies bedeutet, daß in der Schaltung zwei Ausgangssignale unterschiedlicher Polarität geführt werden. Bei der Verarbeitung dieser Signale, beispielsweise durch Subtraktion, tritt der Vorteil ein, daß auf die Ausgangssignale mit gleichem Vorzeichen eingekoppelte Störungen sich aufheben, daß die Nutzanteile der Ausgangssignale sich jedoch gleichsinnig überlagern.

Das Ausgangssignal F des Spannungsstromwandlers 11 gelangt auf erste Versorgungsanschlüsse 21 und 22 der spannungsgesteuerten Stromquellen 18 und 19. Zweite Versorgungsanschlüsse 23 und 24 dieser spannungsgesteuerten Stromquellen sind mit dem Potential S des Substrates gekoppelt, auf dem der Phasenregelkreis gemäß Fig. 1 (evtl. mit Ausnahme des Widerstandes 6) aufgebaut ist. Dies hat zur Folge, daß die stromgesteuerten Spannungsquellen 18 und 19 bezogen auf das Potential S des Substrats arbeiten, so daß sich auf das Substrat S aufgekoppelte Störpotentiale insofern nicht auswirken, als die stromgesteuerten Spannungsquellen 18 und 19 ebenfalls bezogen auf dieses Potential arbeiten. Damit treten in deren Signalen relativ zu dem Potential S diese Störungen nicht auf.

Beide spannungsgesteuerte Stromquellen 18 bzw. 19 weisen jeweils einen nicht-invertierenden Eingang 25 bzw. 26 sowie einen invertierenden Eingang 27 bzw. 28 auf. Ferner weisen beide spannungsgesteuerte Stromquellen 18 bzw. 19 jeweils einen nicht-invertierenden Ausgang 29 bzw. 30 sowie einen invertierenden Ausgang 31 bzw. 32 auf. Zwischen den invertierenden Ausgang 31 und den nicht-invertierenden Ausgang 29 der spannungsgesteuerten Stromquelle 18 ist eine Kapazität 33 und zwischen die entsprechenden Ausgänge 32 und 30 der spannungsgesteuerten Stromquelle 19 ist eine Kapazität 34 geschaltet, die gegebenenfalls auch nur aus parasitären Kapazitäten bestehen kann.

Der invertierende Ausgang 31 der spannungsgesteuerten Stromquelle 18 ist mit dem nicht-invertierenden Eingang 26 der spannungsgesteuerten Stromquelle 19 gekoppelt. Ferner ist der nicht-invertierende Ausgang 29 der spannungsgesteuerten Stromquelle 18 mit dem invertierenden Eingang 28 der spannungsgesteuerten Stromquelle 19 gekoppelt.

Das Ausgangssignal des invertierenden Ausgangs 32 der spannungsgesteuerten Stromquelle 19 ist einerseits einem ersten Eingang 35 der Auskoppelstufe 20 zugeführt und ferner auf den invertierenden Eingang 27 der spannungsgesteuerten Stromquelle 18 rückgekoppelt. In entsprechender Weise stellt das Ausgangssignal des nicht-invertierenden Ausgangs 30 der spannungsgesteuerten Stromquelle 19 ein Signal $\overline{IN}$ dar, das einem zweiten Eingang 36 der Auskoppelstufe 20 zugeführt wird und das auf den nicht-invertierenden Eingang 35 der spannungsgesteuerten Stromquelle 18 rückgekoppelt ist.

Durch diese Art der Rückkopplung wird erreicht, daß die beiden spannungsgesteuerten Stromquellen 18 bzw. 19 ein Schwingungs-Signal liefern, dessen Frequenz von den Kapazitäten 33 und 34 und von dem Strom abhängt, der den spannungsgesteuerten Stromquellen 18 und 19 an deren ersten Versorgungsanschlüssen 21 bzw. 22 zugeführt wird. Die beiden spannungsgesteuerten Stromquellen 18 und 19 stellen mit samt ihrer Verschaltung einen Oszillator dar, der differentiell aufgebaut ist. In der Schaltung werden die Signal jeweils mit zwei Polaritäten geführt. Dieser Schaltungsteil des gesteuerten Oszilators 17 arbeitet bezogen auf das Potential S des Substrats, auf dem der Phasenregelkreis aufgebaut ist. Auch die Ausgangssignale in und in quer sind auf dieses Potential S bezogen. Damit treten in diesen Ausgangssignalen Störungen, die auf das Potential S des Substrats eingekoppelt werden, nicht in Erscheinung.

Die Auskoppelstufe 20 verarbeitet diese Signale dahingehend, daß sie ausgangsseitig Signale OUT und $\overline{OUT}$ liefert, die ebenfalls differentiell sind und die auf das Bezugspotential $V_{ss}$ bezogen sind, auf das auch die übrigen Signale des Phasenregeikreises bzw. dessen Schaltungselemente bezogen sind. Die Auskoppelstufe 20 hat also im wesentlichen die Aufgabe, den Bezug der Eingangssignale IN und $\overline{IN}$, die auf das Potential des Substrats bezogen sind, umzuwandeln in Ausgangssignale, die auf das Bezugspotential $V_{ss}$ der übrigen Schaltungselemente bezogen sind. Dabei sollen sich auf das Substrat S eingekoppelte Störungen auch in den auf das Bezugspotential $V_{ss}$ bezogenen Ausgangssignalen möglichst wenig auswirken.

Die Auskoppelstufe 20 des Phasenregelkreises gemäß Fig. 1 ist in Fig. 2 in Form eines Detailschaltbildes dargestellt.

In der Darstellung gemäß Fig. 2 gelangt das Signal IN auf den Verbindungspunkt der Gates zweier N-MOS-Transistoren 41 und 42, welche mit ihren Source-Anschlüssen jeweils mit dem Substrat S des Potentials des Substrats gekoppelt sind. Entsprechend sind zwei weitere N-MOS-Transistoren 43 und 44 verschaltet, auf die das Signal $\overline{IN}$ geführt wird. Über als Kaskode fungierende Transistoren 45, 46, 47 und 48, deren Gates mit dem Potential F des gesteuerten Oszilators 17 verbunden sind, sind die Drain-Anschlüsse der Transistoren 41, 42, 43 und 44 mit zwei Stromspiegelschaltungen gekoppelt. Die Transistoren 41 und 42 sind mit einer aus zwei Transistoren 49 und 50 aufgebauten Stromspiegelschaltung gekoppelt, wohingegen die Transistoren 43 und 44 mit einer zweiten Stromspiegelschaltung gekoppelt sind, die aus Transistoren 51 und 52 aufgebaut sind.

Es sind ferner zwei P-MOS-Feldeffekttransistoren 53 und 54 vorgesehen, welche als Schalter arbeiten, die also zwischen ihren zwei Betriebszuständen leitend und nichtleitend geschaltet werden. Der Transistor 53 ist mit seinem Gate mit dem von dem Transistor 43 geführten Signal gekoppelt. Mit Source und Drain ist er zwischen den Ausgang der durch die Transistoren 49 und 50 gebildeten Stromquelle und den Transistor 42 geschaltet. Das Gate des Transistors 54 ist mit dem von dem Transistor 42 geführten Signal gekoppelt und mit seinen Source- und Drain-Anschlüssen zwischen den Transistor 43 und den Ausgang der durch die Transistoren 51 und 52 gebildeten Stromquelle geschaltet.

Der Verstärker arbeitet als Komparator auf Basis eines Speicher-Flip-Flops. Die P-Kanal-Transistoren 53, 54 sind zusammen mit den als Lasten wirkenden Stromquellen 50, 51 als Speicher-Flip-Flop geschaltet.

Die Transistoren 42, 43 setzen die Eingangsspannungen IN und $\overline{IN}$ in entsprechende Strome um, mit denen das Speicher-Flip-Flop gespeist wird. Die Transistoren 42, 43 setzen die Eingangsspannungen IN und $\overline{IN}$ in entsprechende Ströme um, die aufsummiert über die beiden parallel als Dioden geschalteten Transistoren 49 und 52 fließen. Die Spiegeltransistoren 50 und 51 führen deshalb einen Strom, der dem Mittelwert der Ströme durch die Transistoren 50 und 51 entspricht. Das Speicher-Flip-Flop wird deshalb durch die Differenz der Eingangsströme gesteuert, wodurch die Umwandlung der differentiellen Eingangssignale in zwei komplementäre, auf Bezugspotential bezogene Signale erfolgt.

Da dieser Komparator seine Entscheidung aufgrund der hochverstärkten differentiellen Signale trifft, erfolgt eine gute Unterdrückung für Gleichtaktstörungen.

Die Transistoren 45 - 48 arbeiten als Kaskoden, wodurch u.a. eine Entkopplung der Kapazität des Ausgangs des Speicher-Flip-Flops von den Millerkapazitäten der Transistoren 42 und 43 vorgenommen wird. Die Auskopplung des Zustandes des Speicher-Flip-Flops erfolgt über Inverter mit minimaler Gatefläche, um die geschwindigkeitsbestimmenden Ausgangsknoten des Speicher-Flip-Flops nicht zu stark zu belasten.

Da bei der Auskopplung des Zustandes des Speicher-Flip-Flops auf die Inverter 56, 57 vom Substratpotential S auf das Bezugspotential $V_{ss}$ gewechselt wird, können auch hier Störungen durch Potentialunterschiede eingekoppelt werden. Wenn die Flankensteilheit der Eingangssignale für die Inverter 56, 57 nicht groß genug ist, müssen die Inverter 56, 57 durch eine Speicher-Flip-Flop-Schaltung mit Bezugspotential $V_{ss}$ ersetzt werden. Diese Schaltung bewirkt dann die endgültige differential to single Konvertierung.

Die Ausgangssignale des ersten Teils der Auskoppelstufe, der mittels der Transistoren 41 bis 34 aufgebaut ist und bei denen es sich um hart geschaltete Signale handelt, die quasi digitale Signale darstellen, gelangen auf Inverter 56 und 57, die auf das Bezugspotential $V_{ss}$ bezogen arbeiten. Der Inverter 57 liefert ausgangsseitig das Signal OUT, das das Ausgangssignal der gesamten Schaltungsanordnung und das zweite Eingangssignal für den Phasendetektor 1 gemäß Fig. 1 darstellt. Der zweite Inverter 56 liefert ein invertiertes Signal $\overline{OUT}$.

In dem Phasenregelkreis gemäß Fig. 1 wird eine doppelte Unterdrückung gegen Störungen erreicht, die auf das Potential S des Substrates eingekoppelt werden, auf dem der Phasenregelkreis aufgebaut ist Einerseits wird durch den kapazitiven Spannungsteiler eine Unterdrückung dieser Störungen entsprechend dem Teilerverhältnis dieses Teilers erreicht. In der nachfolgenden Schaltung des gesteuerten Oszillators 17 wird dieses Signal so weiterverarbeitet, daß dort ebenfalls auf das Substrat S eingekoppelte Störungen weitgehend unterdrückt werden bzw. sich möglichst wenig auf die Nutzsignale des gesteuerten Oszillators 17 auswirken. Damit ist das Ausgangssignal OUT (sowie das invertierte $\overline{OUT}$) weitgehend frei von Störungen, d.h. also von Phasenschwankungen, die bei Phasenregelkreisen unerwünscht sind. Im Ergebnis wird für die gesamte Schaltung eine deutliche Störverminderung erzielt, da auch das Eingangssignal OUT des Phasendetektors 1 weitgehend störungsbefreit ist. Diese Vorteile werden erzielt, ohne daß Nachteile bezüglich des dynamischen Verhaltens oder anderer Eigenschaften der Schaltung in Kauf genommen werden müssen.

**Patentansprüche**

1. Phasenregelkreis mit einem Phasendetektor (1), einem Schleifenfilter (5) und einem gesteuerten Oszillator (17), die auf einem integrierten Schaltkreis realisiert sind, dadurch gekennzeichnet, daß dem gesteuerten Oszillator (17) ein kapazitiver Spannungsteiler (9), der wenigstens zwei Kapazitäten (10, 12) aufweist, vorgeschaltet ist, daß der gesteuerte Oszillator (17) in Abhängigkeit des Ausgangssignals des kapazitiven Spannungsteilers (9) gesteuert wird und daß der kapazitive Spannungsteiler (9) mit dem Phasendetektor (1), dem Schleifenfilter (5) und dem gesteuerten Oszillator (17) auf einem integrierten Schaltkreis aufgebaut ist.

2. Phasenregelkreis nach Anspruch 1, dadurch gekennzeichnet, daß wenigstens eine erste Kapazität (10) des kapazitiven Spannungsteilers (9) in den Signalweg zwischen dem Phasendetektor (1) und dem Schleifenfilter (5) einerseits und dem gesteuerten Oszillator (17) andererseits geschaltet ist und daß wenigstens eine zweite Kapazität (12) des kapazitiven Spannungsteilers (9) zwischen diesen Signalweg und ein Versorgungspotential geschaltet ist.

3. Phasenregelkreis nach Anspruch 1, dadurch gekennzeichnet, daß der gesteuerte Oszillator (17) einen Spannungs-/Strom-Wandler (11) aufweist, in Abhängigkeit von dessen Ausgangsstrom die Frequenz des Ausgangssignals des gesteuerten Oszillators (17) variiert wird.

4. Phasenregelkreis nach Anspruch 3, dadurch gekennzeichnet, daß wenigstens eine erste Kapazität (10) des kapazitiven Spannungsteilers (9) in den Signalweg zwischen dem Phasendetektor (1) und dem Schleifenfilter (5) einerseits und dem Spannungs/Strom-Wandler (11) andererseits geschaltet ist und daß wenigstens eine zweite Kapazität (12) des kapazitiven Spannungsteilers (9) zwischen diesen Signalweg und ein Versorgungspotential geschaltet ist.

5. Phasenregelkreis nach einem der Ansprüche 1 bis 4, dadurch gekennzeichnet, daß wenigstens ein als Diode verschalteter Transistor (14; 13) vorgesehen ist, mittels welchem das Gleichspannungs-Potential am Ausgang des kapazitiven Spannungsteilers (9) eingestellt wird.

6. Phasenregelkreis mit einem Phasendetektor (1), einem Schleifenfilter (5) und einem gesteuerten Oszillator (17), die auf einem integrierten Schaltkreises realisiert sind, dadurch gekennzeichnet, daß der geteuerte Oszillator (17) differentiel aufgebaut ist und wenigstens zwei spannungsgesteuerte Stromquellen (18,19) aufweist, deren Schaltungen mit einem Versorgungspotential und mit einem Substrat gekoppelt sind, auf dem der integrierte Schaltkreis aufgebaut ist, daß der geteuerte Oszillator (17) eine Auskoppelstufe (20) aufweist, die den spannungsgesteuerten Stromquellen (18,19) nachgeschaltet ist und die in Abhängigkeit der ihr zugeführten differentiellen Signale zwei differentielle digitale Signale generiert, die mittels Umschaltung zwischen zwei Potentialen mit hoher Flankensteilheit erzeugt werden und die Verstärkerstufen (56,57) zugeführt werden, die zwischen Versorgungspotential und Bezugspotential geschaltet sind und die zwei auf Bezugspotential bezogene differentielle Ausgangssignale liefern.

7. Phasenregelkreis nach Anspruch 6, dadurch gekennzeichnet, daß den Verstärkerstufen (56, 57) eine weitere Verstärkerstufe nachgeschaltet ist, welche aus den differentiellen Ausgangssignalen der Verstärkerstufen (56, 57) ein single-ended-Signal formt.

8. Phasenregelkreis nach Anspruch 6 oder 7, dadurch gekennzeichnet, daß der Oszillator (17) mittels eines Stromes angesteuert wird, der ersten Versorgungsanschlüssen (21,22) der spannungsgesteuerten Stromquellen (18,19) zugeführt wird, deren zweite Versorgungsanschlüsse (23,24) mit dem Substrat des integrierten Schaltkreises gekoppelt sind.

9. Phasenregelkreis nach einem der Ansprüche 6 bis 8, dadurch gekennzeichnet, daß eine erste (18) und eine zweite (19) spannungsgesteuerte Stromquelle vorgesehen sind, welche jeweils einen nicht-invertierenden (25;26) und einen invertierenden (27;28) Eingang und einen nicht-invertierenden (29;30) und einen invertierenden (31;32) Ausgang aufweisen, daß beide Ausgangssignale beider spannungsgesteuerten Stromquellen (18,19) jeweils mittels wenigstens einer Kapazität (33;34) miteinander gekoppelt sind, daß der invertierende Ausgang (31) der ersten spannungsgesteuerten Stromquelle (18) mit dem nichtinvertierenden Eingang (26) der zweiten spannungsgesteuerten Stromquelle (19) und der nichtinvertierende Ausgang (29) der ersten spannungsgesteuerten Stromquelle (18) mit dem invertierenden Eingang (28) der zweiten spannungsgesteuerten Stromquelle (19) gekoppelt ist, daß der invertierende Ausgang (32) der zweiten spannungsgesteuerten Stromquelle (19) mit dem invertierenden Eingang (27) der ersten Stromquelle (18) und der nichtinvertierende Ausgang (30) der zweiten spannungsgesteuerten Stromquelle (19) mit dem nicht-invertierenden Eingang (25) der ersten spannungsgesteuerten Stromquelle (18) gekoppelt ist und daß die Ausgangssignale der zweiten spannungsgesteuerten Stromquelle (19) die differentiellen Signale darstellen die auf die Auskoppelstufe (20) geführt sind.

10. Phasenregelkreis nach den Ansprüchen 1 und 6, dadurch gekennzeichnet, daß der gesteuerte Oszillator (17) in Abhängigkeit des Ausgangssignals des kapazitiven Teilers (9) angesteuert wird.

11. Schaltungsanordnung zur Wandlung eines analogen Bildsignals in ein digitales Bildsignal und zur Decodierung des digitalen Bildsignals, welche wenigstens teilweise mittels des Ausgangssignals eines Phasenregelkreises nach einem der Ansprüche 1 bis 10 getaktet wird.

12. Bildwiedergabeanordnung mit einer Schaltungsanordnung nach Anspruch 11.

Fig.1

Fig.2